# EUROPEAN PATENT SPECIFICATION

(11) **EP 3 419 175 B1**
(45) Date of publication and mention of the grant of the patent: **19.08.2020**
(21) Application number: 18179455.3
(22) Date of filing: 25.06.2018
(51) Int. Cl.: H03K 17/96

(54) **TOUCH SENSOR ASSEMBLY**
BERÜHRUNGSSENSORANORDNUNG
ENSEMBLE CAPTEUR TACTILE

(30) Priority: 23.06.2017 KR 20170079559; 26.06.2017 KR 20170080356
(43) Date of publication of application: 26.12.2018
(73) Proprietor: LG Electronics Inc., Yeongdeungpo-gu Seoul 07336 (KR)
(72) Inventor: Park, Seungje, 08592 Seoul (KR); Yang, Jaesung, 08592 Seoul (KR); Kim, Hyunki, 08592 Seoul (KR)
(74) Representative: Ter Meer Steinmeister & Partner

(56) References cited:
- EP-A1- 0 525 374
- US-A1- 2016 105 985

## Description

### BACKGROUND

The present specification relates to a touch sensor assembly.

Refrigerators may be classified into a top mount type refrigerator in which a freezing compartment is located above a refrigerating compartment, a bottom freezer type refrigerator in which a refrigerating compartment is located above a freezing compartment, and a side-by-side type refrigerator in which a refrigerating compartment and a freezing compartment are respectively located at left and right sides, according to the configurations of the refrigerating compartment and the freezing compartment.

The side-by-side type refrigerator is mainly released as a refrigerator having a relatively large capacity and various functions, and includes a freezing compartment and a refrigerating compartment which are vertically installed at the left and right sides of the refrigerator. An evaporator is provided on the rear surface of the freezing compartment to suck air from the lower portions of the freezing compartment and the refrigerating compartment and to discharge air upward, thereby circulating cool air in the compartments to perform the refrigerating function and the freezing function.

In general, refrigerator doors are rotatably installed on a front surface of a refrigerator and are exposed to a user in a state in which storage compartments are closed. In consideration of the usage of the refrigerator, in which a time to keep the refrigerator door open is small during a day, the front surface of the door of the refrigerator is decorated with a panel having various patterns or a front panel of the door is made of a luxurious exterior material, in order to provide an aesthetically pleasing appearance.

Recently, users have a high preference for a material of home appliances made of metal. When a display for confirming operation information of a refrigerator and buttons for operating the refrigerator are installed on a front surface of a door of the refrigerator, the appearance of the refrigerator may be deteriorated.

In consideration of this, recently, research into a door structure in which display information and buttons are not usually displayed and are displayed only when a user desires to view the display information and the buttons is actively being conducted.

It is difficult to apply an electrostatic touch method to a door having a front panel made of a metal material. In addition, since the metal material itself has certain rigidity, it is not easy to implement a static-pressure type touch method. In particular, it is difficult to implement a hidden button on a panel made of a metal material using a conventional touch sensing method.

Accordingly, there is a need for development of a sensor capable of reliably recognizing a touch operation even in a panel made of a metal material. Such a sensor is applicable not only to a front panel of a refrigerator door but also to various home appliances having a metal panel and capable of applying a hidden button for performing a touch operation to the metal panel and thus is widely used in various fields.

In the above-described metal touch sensor, when force applied upon touch is large or the number of times of pressing a button is increased, a pressing portion and the periphery thereof may be damaged with time.

In the above-described metal touch sensor, when metal connectors are exposed to air for a long time, oxidation may occur, resulting in an abnormal electrical connection of the connectors.

Conventionally, in order to prevent such oxidation, a sealing structure was formed such that the connectors are not exposed to air.

However, such a sealing structure is complicated and a process of manufacturing the same is complicated, thereby decreasing productivity of the metal touch sensor. In addition, the sealing structure increases the size of the metal touch sensor and increases manufacturing costs.

EP 0 525 374 A1 discloses a piezoelectric key switch. The piezoelectric key switch includes a housing which contains a recess, which starts from its front. In the recess, a disc-shaped compensating element of rubber, a disc-shaped piezoceramic element mounted thereon, an annular spacer and an operating plate are located stacked on top of one another. All these elements are bonded to one another with their flat areas. The opening of the recess has an outside contour corresponding to the outside contour of the operating plate which is flush with the area of the front of the housing in the non-operated state. On the rear of the operating plate, protrusions protrude into the recess which limit the stroke of the operating plate. The housing can be made of a combination of stainless steel and another metal. The housing can also be made of other metals, such as aluminum, which can be anodized on the front surface of the housing and thus become very resistant to corrosion.

### SUMMARY

An object of the present invention is to provide a touch sensor assembly having a small number of parts, a simple manufacturing method and high touch operation sensing reliability.

Another object of the present invention is to provide a touch sensor assembly capable of preventing a pattern connecting an electrical signal from being disconnected due to repeated use and fatigue accumulation.

Another object of the present invention is to provide a touch sensor assembly capable of operating even when any one pattern is disconnected.

Another object of the present invention is to provide a touch sensor assembly capable of preventing failure which occurs when a pattern connecting an electrical signal is disconnected and increasing the lifespan of a product.

Another object of the present invention is to provide a touch sensor assembly capable of reducing possibility of damage by forming a line, through which a pattern connecting an electrical signal passes, in the form of a curved line to increase a withstanding load as compared to a straight line.

Another object of the present invention is to provide a touch sensor assembly capable of preventing oxidation of a piezo disk and a touch substrate without a complicated sealing structure.

Another object of the present invention is to provide a touch sensor assembly capable of preventing electrical contact failure due to oxidation of a piezo disk and a touch substrate.

Another object of the present invention is to provide a touch sensor assembly capable of reducing a cost and improving productivity by removing a sealing structure.

Another object of the present invention is to provide a touch sensor assembly having high touch operation sensitivity.

Another object of the present invention is to provide a touch sensor assembly having robustness and high durability.

Another object of the present invention is to provide a touch sensor assembly having a high degree of freedom in design.

Another object of the present invention is to provide a touch sensor assembly which can be easily and manually manufactured and can be automated.

Another object of the present invention is to provide a touch sensor assembly which can be robustly assembled and can increase touch operation sensing reliability.

According to the invention, a touch sensor assembly includes a touch substrate attached to a rear surface of a panel having a touch point, a piezo disk having first and second poles stacked thereon, wherein the first pole is disposed on at least a central portion of a front surface thereof and aligned in a direction facing the touch substrate to be fixed to a rear surface of the touch substrate, a pressing part flexibly provided on the touch substrate, electrically connected to the first pole upon being in contact with the first pole, and electrically connected to a wiring provided on the touch substrate, a fixing surface electrically connected to the second pole while supporting the second pole such that the piezo disk is fixed to the rear surface of the touch substrate and electrically connected to second wirings provided on the touch substrate.

In addition, the touch sensor assembly comprises an oxidation prevention film coated on at least one of the first pole or the second pole of the piezo disk and the pressing part or the fixing surface of the touch substrate and made of a conductive material. Accordingly, it is possible to prevent oxidation of the piezo disk and the touch substrate without a complicated sealing structure and to prevent electrical contact failure due to oxidation of the piezo disk and the touch substrate.

In addition, the oxidation prevention film may be made of carbon or gold (Au).

In addition, the oxidation prevention film may be coated using a silk screen method.

In addition, a hole may be provided at a position of the touch substrate corresponding to the touch point. The pressing part may be connected to a leg part extending from an inner circumferential surface of the hole to a central portion of the hole.

In addition, the first wiring may be electrically connected to the pressing part through the leg part.

In addition, the leg part may be radially provided around the pressing part.

In addition, the leg part may have an asymmetric structure with respect to the pressing part.

In addition, a holder for providing fixing force for fixing the piezo disk to the rear surface of the touch substrate by supporting a side surface and a rear surface of the piezo disk may be fixed to the fixing surface.

In addition, the holder may be made of a conductive material, and the second pole of the piezo disk may be electrically connected to the fixing surface.

In addition, the holder may include a rear support part supporting a rear surface of the piezo disk. The holder may include a side support part extending from an edge of the rear support part toward the touch substrate to support the side surface of the piezo disk. The holder may include a fixing leg part extending from the side support part outwardly in a direction parallel to a plane including the touch substrate to be fixed to the fixing surface of the touch substrate.

In addition, an insertion hole opened to insert the piezo disk may be formed in one side of the rear support part.

In addition, a guide groove recessed inward may be provided in an edge of the rear support part including the insertion hole in order to guide insertion of the piezo disk.

In addition, the insertion hole may be formed toward the outside of the touch substrate.

In addition, pressing projections protruding forwardly to press the rear surface of the piezo disk forwardly may be provided on the rear support part. The pressing projections may press edges of the rear surface of the piezo disk.

In addition, slits may be formed around the center of the rear support part.

A first adhesive member for providing adhesive strength to adhere the touch substrate to the rear surface of the panel may be stacked on a front surface of the touch substrate.

### BRIEF DESCRIPTION OF THE DRAWINGS

FIG. 1 is a view showing a front surface of a refrigerator, to which a touch sensor assembly according to the present invention is applied.
FIG. 2 is a perspective view showing a door portion of the refrigerator of FIG. 1.
FIG. 3 is a partial exploded perspective view of the refrigerator of FIG. 2.
FIG. 4 is an exploded perspective view of the touch sensor assembly shown in FIG. 3.
FIG. 5 is an enlarged view of a portion A of the touch substrate shown in FIG. 4.
FIG. 6 is a front view and a rear view showing the other embodiments of the portion of the touch substrate shown in FIG. 5.
FIG. 7 is an enlarged view and a side view of a portion B which is one of the piezo disks shown in FIG. 4.
FIG. 8 is an enlarged view of a portion C which is one of holders shown in FIG. 4.
FIG. 9 is a cross-sectional view of a piezo disk installation portion of the touch sensor assembly when viewed in an X-X direction of FIG. 2 in a state of assembling the touch sensor assembly of FIG. 4.
FIG. 10 is a front view showing a state in which the touch substrate, the holder and the piezo disk of the touch sensor assembly of FIG. 4 are assembled.
FIG. 11 is a rear view of FIG. 10.

### DETAILED DESCRIPTION OF THE EMBODIMENTS

Hereinafter, some embodiments of the present invention will be described in detail with reference to exemplary drawings. It is to be noted that, in adding reference numerals to the constituent elements of the drawings, the same constituent elements are denoted by the same reference numerals whenever possible, even if they are shown in different drawings. In the following description of the embodiments of the present invention, well-known functions or constructions are not described in detail since they would obscure the understanding of the embodiments of the present invention.

It will be understood that, although the terms first, second, A, B, (a), (b), etc. may be used herein to describe various elements of the present invention, these terms are only used to distinguish one element from another element and essential, order, or sequence of corresponding elements are not limited by these terms. It will be understood that when one element is referred to as "being connected to", "being coupled to", or "accessing" another element, one element may "be connected to", "be coupled to", or "access" another element via a further element although one element may be directly connected to or directly access another element.

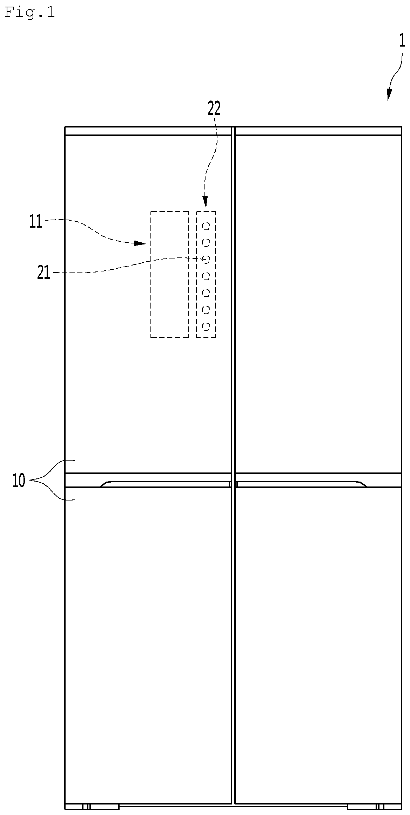

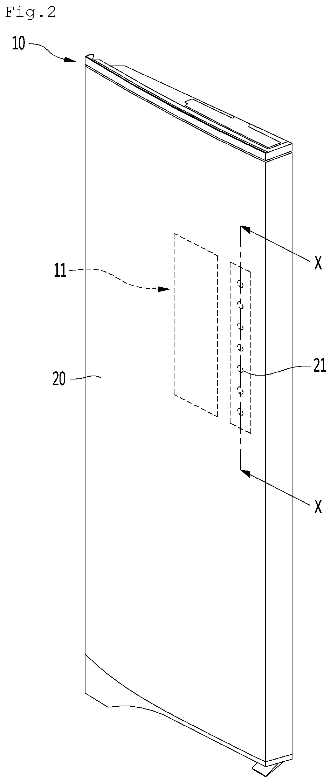

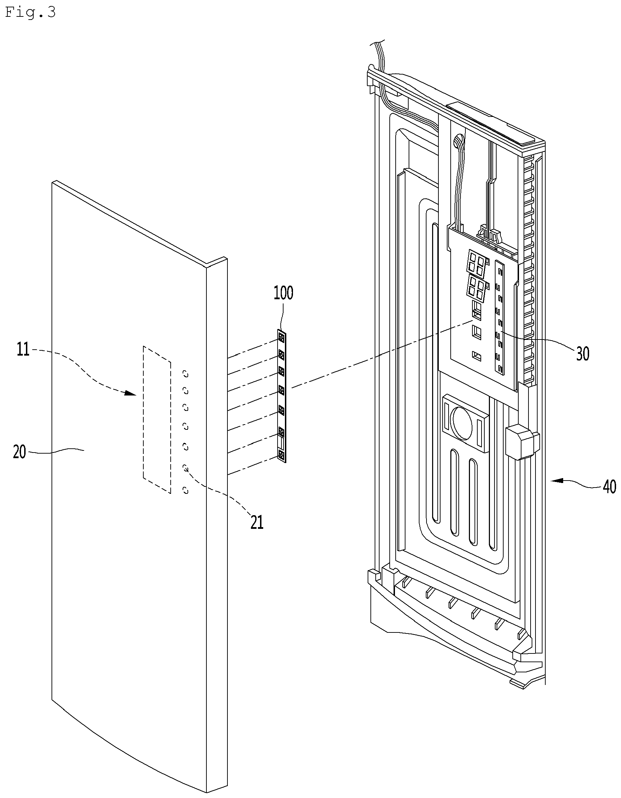

FIG. 1 is a view showing a front surface of a refrigerator, to which a touch sensor assembly according to the present invention is applied, FIG. 2 is a perspective view showing a door portion of the refrigerator of FIG. 1, and FIG. 3 is a partial exploded perspective view of the refrigerator of FIG. 2.

As shown in FIG. 1, the appearance of the refrigerator 1 according to the embodiment of the present invention is defined by a cabinet for providing a storage space and refrigerator doors 10 installed on the cabinet to open and close the storage space.

The storage space provided by the cabinet may be partitioned into left and right sides and/or upper and lower sides, and a plurality of refrigerator doors 10 for opening and closing the storage space is provided on a front surface of the partitioned storage space. The doors 10 are configured to open and close the storage space in a sliding or rotation manner and the doors configures the front appearance of the refrigerator in a state of closing the doors.

On a door 10, which corresponds to an eye level of a user having an average height, of the plurality of refrigerator doors 10, a display region 11 and a touch region 22 is provided at a height where a user can easily identify or operate the regions.

The display region 11 displays the operation state of the refrigerator 1 to the outside and is configured to display symbols or numerals as light irradiated from an internal space of the door 10 is transmitted (see FIG. 2), such that the user can check the operation information of the refrigerator.

When light is not irradiated from the internal space of the door, the display region 11 is not displayed (see FIG. 1). In this state, the display region 11 seems to be not present in the door 10, thereby implementing a clear appearance.

The touch region 22 is used for a user to perform a touch operation for operating the refrigerator 1 and is provided near the display region 11. A plurality of touch points 21 is provided in the touch region 22. When the user presses a touch point 21, an operation corresponding thereto is performed. The touch points 21 may be displayed to be recognized by the user by a printing process or a surface processing method such as etching.

Of course, the touch region 22 may not be installed on the same door 10 as the display region 11 and may be installed on another door 10 or on one side of a cabinet.

In addition, the touch points 21 may not be displayed so as to be always identified and the positions thereof may or may not be recognized depending on whether light is irradiated from the inside of the door or not, as in the display region 11.

A front panel 20 may be made of a metal plate such as a steel or stainless steel plate. A touch sensor assembly 100 is fixed to a rear surface of a portion corresponding to the touch region 22 of the front panel 20. A support structure 30 may be installed inside a door liner 40 fastened to the rear side of the front panel 20, in order to increase adhesive strength between the touch sensor assembly 100 and the front panel 20. When the front panel 20 and the door liner 40 are fastened in a state of fixing the touch sensor assembly 100 to the rear surface of the front panel 20, the support structure 30 installed on the door liner 40 presses the rear surface of the touch sensor assembly 100 to support the touch sensor assembly 100 forward.

In addition, by fastening the front panel 20 and the door liner 40 in a state of fixing the touch sensor assembly 100 to the front surface of the support structure 30, the front surface of the touch sensor assembly 100 may be adhered to the rear surface of the front panel 20. In addition, it should be understood that various supporting methods including a method of assembling the front panel 20 and the door liner 40 to support the touch sensor assembly 100 toward the front panel 20 are possible.

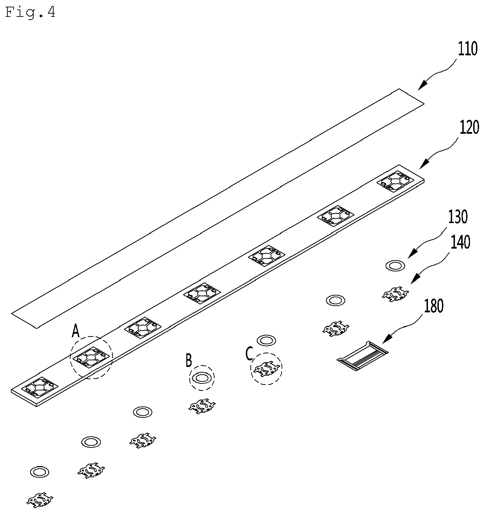

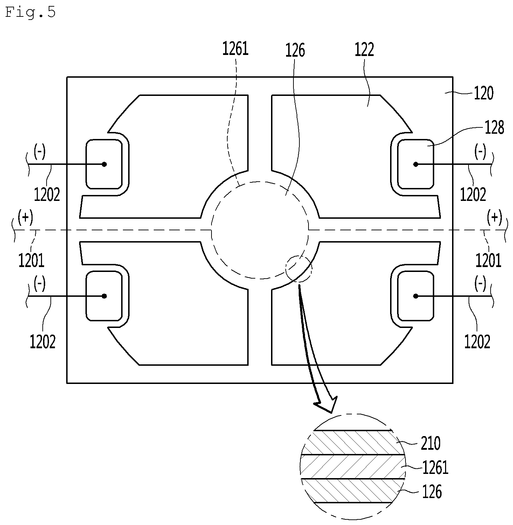

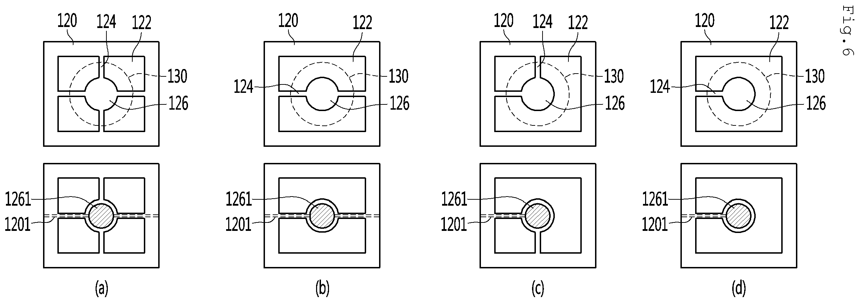

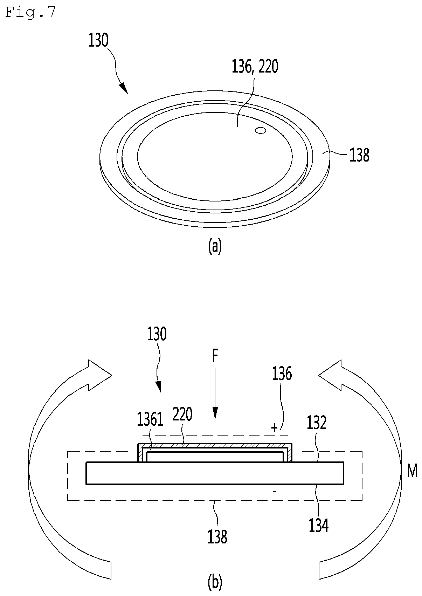

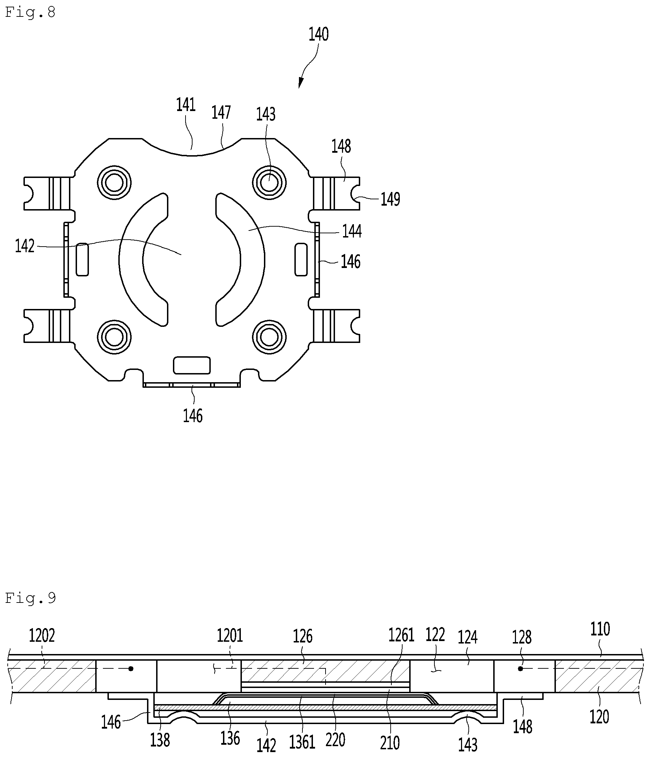

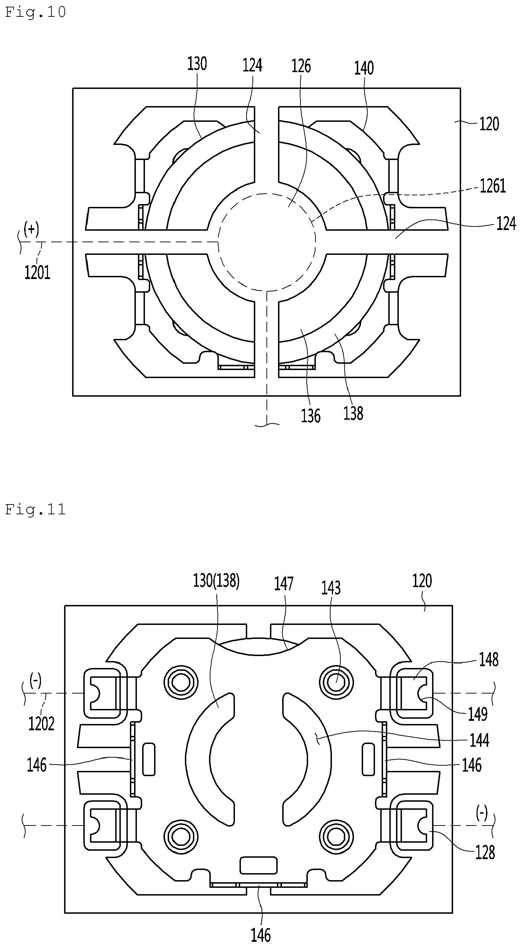

FIG. 4 is an exploded perspective view of the touch sensor assembly shown in FIG. 3, FIG. 5 is an enlarged view of a portion A of the touch substrate shown in FIG. 4, FIG. 6 is a front view and a rear view showing the other embodiments of the portion of the touch substrate shown in FIG. 5, FIG. 7 is an enlarged view and a side view of a portion B which is one of the piezo disks shown in FIG. 4, FIG. 8 is an enlarged view of a portion C which is one of holders shown in FIG. 4, FIG. 9 is a cross-sectional view of a piezo disk installation portion of the touch sensor assembly when viewed in an X-X direction of FIG. 2 in a state of assembling the touch sensor assembly of FIG. 4, FIG. 10 is a front view showing a state in which the touch substrate, the holder and the piezo disk of the touch sensor assembly of FIG. 4 are assembled, and FIG. 11 is a rear view of FIG. 10.

Hereinafter, the overall structure of the touch sensor assembly and the structures of the individual components configuring the touch sensor assembly will be described in detail with reference to FIGS. 4 to 11.

Referring to FIGS. 4 and 9, the touch sensor assembly 100 includes a touch substrate 120 and a piezo disk 130.

The touch substrate 120 may be made of a printed circuit board (PCB) having a certain thickness.

A first adhesive member 110 such as a double-sided adhesive tape is adhered to an outer surface, that is, the opposite surface of the surface on which the piezo disk is provided, of the touch substrate 120 to be water-tighten with respect to the touch substrate 120 and the structure stacked thereon and the outer surface of the touch substrate 120 may be attached to the rear surface of the front panel 20 of the refrigerator door.

A second adhesive member (not shown) is attached to the touch substrate 120, the piezo disk 130 and the outer surface, that is, the opposite surface of the surface on which the touch substrate 120 is stacked, of a holder 140 to be water-tighten with respect to the touch substrate 120, the piezo disk 130 and the holder 140.

The touch substrate 120 corresponds to the touch region 22 including the plurality of touch points 21 provided on the front panel 20 configuring the door 10 of the refrigerator 1. In the embodiment of the present invention, the plurality of touch points 21 is arranged on the front panel 20 to be spaced apart from each other in a line and the touch region 22 is formed in an elongated rectangular shape (see FIGS. 1 to 3). Accordingly, the touch substrate 120 may be formed in an elongated rectangular shape.

Referring to FIG. 5, a hole 122 is provided in the touch substrate 120 at a position corresponding to the touch point 21 of the front panel 20. In the embodiment of the present invention, the hole is substantially rectangular but the shape of the hole is not limited thereto. The center of the hole 122 may be aligned with the center of the touch point 21 of the front panel 20.

A leg part 124 extending from an inner circumferential surface to the center of the hole 122 is provided in the inner circumferential surface of the hole 122. A pressing part 126 aligned with the center of the hole is connected to the front ends of the leg parts 124.

The shape of the pressing part 126 corresponds to that of the piezo disk 130 and the size thereof may be slightly less than that of the piezo disk 130. In the present invention, the piezo disk 130 and the circular pressing part 126 corresponding thereto are shown. The pressing part 126 and the inner circumferential surface of the hole 122 having the rectangular shape are connected to each other by the leg part 124 extending from the center of each side of the rectangle to the pressing part.

The structure in which the hole 122 is provided in the touch substrate 120 and the pressing part 126 provided at the center of the hole is connected by the leg part 124 makes the pressing part 126 flexible. That is, when the user presses the touch point 21 of the front panel, the pressing force is applied to the pressing part 126. Since the pressing part 126 is connected to the main body of the touch substrate 120 through the plurality of relatively thin leg part 124, the pressing part 126 may be pressed by the pressing force of the user.

Accordingly, in the embodiment of the present invention, the structure in which the pressing part 126 is provided at the center of the hole 122 through the four leg parts 124 may be variously changed if the pressing part 126 is easily moved according to the touch pressure of the user and is designed to have sufficient durability against repeated pressing operations. As a modification of the embodiment (see FIGS. 5 and 6(a)) in which the four leg parts are provided at an interval of 90°, a beam structure in which the leg parts are provided at an interval of 180° as shown in (b) of FIG. 6, a cantilever structure in which only two leg parts are provided at an interval of 90° as shown in (c) of FIG. 6 or a cantilever structure in which only one leg part is provided as shown in (d) of FIG. 6 is applicable. In particular, since the cantilever structure is deformed so as to be more conformable to the touch pressure of the user, it is possible to further increase touch sensitivity.

Meanwhile, as shown in FIG. 5, fixing surfaces 128 for fixing the fixing leg parts 148 of the holder 140 are provided in the vicinity of the hole 122. Although the fixing surfaces 128 protruding toward the inside of the hole 122 in a substantially rectangular shape are provided in the embodiment, the positions of the fixing surfaces is not limited thereto.

Since the touch substrate 120 according to the first embodiment is formed in an elongated rectangular shape and the long side of the hole 122 having the rectangular shape is aligned in a direction corresponding to the longitudinal direction of the touch substrate, the touch substrate 120 may become slimmer. In addition, since the fixing surfaces 128 are provided at the short sides of the hole 122, an insertion hole 141 of the holder 140 may be configured to be opened toward the side surface of the touch substrate 120 and thus the piezo disk 130 may be more easily inserted.

The hole 122, the leg part 124, the pressing part 126 and the fixing surface 128 may be simultaneously formed in the touch substrate 120, by punching the hole portion of the touch substrate except for the leg parts 124, the pressing part 126 and the fixing surface 128.

The touch substrate 120 includes electrical wirings, one of which is a first wiring 1201 passing through the pressing part 126 and the leg part 124 and the other of which is a second wiring 1202 connected to the fixing surface 128, in order to determine whether pressure is applied to the piezo disk. That is, when pressure is applied to the piezo disk to generate a potential difference, electromotive force may be sensed through the wirings.

Referring to FIGS. 4, 8 and 9, the holder 140 is fixed to the portion of the hole 122 of the touch substrate 120. When the holder 140 is fixed to the touch substrate 120, the piezo disk may be inserted into and fixed in a space provided by the holder and the touch substrate.

The holder 140 includes a rear support part 142 substantially covering the portion of the hole 122 of the touch substrate and having a rectangular shape. For reference, although the shape of the rear support part 142 is substantially a square, for convenience, the shape of the rear support part 142 is described as being a rectangular shape in correspondence with the rectangular hole 122 of the touch substrate 120. When the holder is fixed to the touch substrate, the rear support part 142 is spaced apart from the surface of the touch substrate by a predetermined gap. The gap between the rear support part 142 and the surface of the touch substrate may be defined by side support parts 146 bent on the outer edge of the rear support part at a substantially right angle. Fixing leg parts 148 fixed to the fixing surfaces 128 of the touch substrate 120 through soldering are provided on the ends of the side support parts 146. The fixing leg parts 148 are electrically connected to the fixing surfaces 128 through soldering.

In some the embodiments, a total of four fixing surfaces 128 of the touch substrate is provided at the short side portions of the rectangular hole 122 and four fixing leg parts 148 are provided at positions corresponding to the fixing surfaces. Each fixing leg part 148 is formed in a planar shape to be in contact with the fixing surface 128, and a via hole 149 may be formed in an end of the fixing leg part in order to increase soldering adhesion with the fixing surface 128. The fixing leg parts 148 are arranged in the longitudinal direction of the touch substrate 120, such that the insertion hole 141 of the holder is opened toward the lateral side (that is, the direction perpendicular to the longitudinal direction) of the touch substrate 120, thereby more easily inserting the piezo disk.

The side support parts 146 are bent at a right angle on two short sides and one long side among the four sides of the rectangular rear support part 142. The side support parts 146 prevent the piezo disk 130 from being separated from the holder 140 in a process of supporting and assembling the side surface of the piezo disk 130 to be inserted into the holder 140. The fixing leg parts 148 are provided at the portions of the side support parts 146 where the two short sides of the rear support part 142 are bent. The long side, on which the side support part 146 is not provided, of the rear support part 142 becomes the insertion hole 141, through the piezo disk 130 is inserted. An arc-shaped guide groove 147 guiding the end of the disk toward the insertion hole 141 upon inserting the piezo disk 130 having the circular plate is provided in the long side portion, which becomes the insertion hole 141, of the side support part 146.

The rear support part 142 becomes a portion supporting the rear surface 134 of the piezo disk 130. Pressing projections 143 pressing and supporting the edges of the rear surface of the piezo disk 130 are provided in the vicinities of the outer edges of the rear support part 142. The pressing projections 143 are provided at positions deviating from a first pole 136 provided on the front surface of the piezo disk 130.

The portion of the first pole 136 provided at the central part of the front surface 132 of the piezo disk 130 slightly protrudes from the front surface of the piezo disk. Such a first pole portion is in contact with the pressing part 126 of the touch substrate and is pressed and supported by the touch substrate. Accordingly, when the pressing projections 143 are provided at the positions deviating from the first pole 136 provided on the front surface of the piezo disk 130, the pressing part 126, which is flexibly moved by the leg parts 124 of the touch substrate 120 to some extent, presses the first pole 136 protruding from the front surface 132 of the piezo disk 130 and the pressing projections 143 of the holder 140 press the edges of the rear surface 134 of the piezo disk 130 deviating from the first pole 136, thereby tightly supporting the piezo disk 130 while minimizing the load applied to a portion where the potential difference of the piezo disk 130 is generated.

In addition, slits 144 having an arc shape are provided around the central point of the rear support part 142 of the holder. Such slits 144 are provided inside the pressing projections 143. The slits 144 may facilitate deformation of the vicinities of the slits. Accordingly, the central portion of the rear support part may be deformed according to deformation of the central portion of the rear surface of the piezo disk 130 which may be finely bent toward the rea surface by the pressing part 126 and the pressing projections 143. The same is true even when the user presses the touch point 21 of the front panel.

The holder 140 may be made of a conductive material such as metal, and a planar metal plate is subjected to press processing or piercing to easily form the pressing projections, the slits, the side support part, etc. The holder 140 is electrically connected to the second wirings 1202 through the fixing surface 128.

Referring to FIG. 7, the piezo disk 130 includes a second pole 138 of a metal plate having a front surface 132 and a rear surface 134 and a first pole 136 stacked on the central portion of the front surface 132. The first pole 136 slightly protrudes from the surface of the second pole 138 at the central portion thereof. The first pole 136 may be made of ceramic and the second pole 138 may be made of a conductive material such as metal. In addition, a conductive layer 1361 such as silver (Ag) may be coated on the surface of the first pole 136.

The piezo disk 130 may be formed in the form of a circular plate and the diameter thereof may be equal to or slightly less than a gap between the two side support parts where the two short sides of the rear support part of the holder are bent.

The piezo disk 130 may be inserted between the touch substrate 120 and the holder 140 fixed to the touch substrate 120 and the guide groove 147 guides insertion of the piezo disk 130 upon inserting the piezo disk. When the piezo disk 130 is inserted, the front surface 132, on which the first pole 136 is provided, faces the touch substrate 120 and the rear surface 134 faces the holder.

When pressure is applied between the first pole and the second pole of the piezo disk 130, a potential difference is generated between the first pole and the second pole. According to the principle of the piezo disk 130, the wiring surface of the pressing part 126 of the touch substrate 120 which is in contact with the first pole 136 of the front surface 132 is exposed to be electrically connected to the first pole, and the wirings 1201 are not exposed so as not to be energized even when the leg part 124 of the touch substrate 120 is in contact with the second pole 138.

In addition, the wiring surface of the pressing part 126 may include a connection material 1261 made of copper or gold and the plurality of first wirings 1201 may be electrically connected to the connection material 1261.

The holder 140 is made of a metal material having electrical conductivity and is electrically connected to the second pole 138 of the rear surface 134.

The first wirings 1201 of the pressing part 126 are connected to the touch substrate 120 through the leg parts 124 to be connected to the wafer 150 and the fixing surface 128 of the touch substrate soldered to the fixing leg parts 148 of the holder 140 are connected to the touch substrate 120 through the second wirings 1202 to be connected to the wafer 150.

Accordingly, when the user presses the touch point 21, the pressing part 126 is pressed with predetermined force F to press the piezo disk 130. At this time, since the pressing part 126 presses the central portion of the front surface 132 of the piezo disk and the pressing projections 143 of the holder 140 supports the edges of the rear surface 134 of the disk, the piezo disk 130 is deformed by the moment M and a potential difference is generated between the first pole 136 and the second pole 138. Minute current according to electromotive force generated by this process is transmitted through the wirings of the touch substrate and the wafer 150 to recognize that the touch point 21 is touched.

Here, the connection material exposed to the pressing part 126 and the conductive layer 1361 coated on the surface of the first pole 136 may be corroded over time.

For example, the connection material 1261 made of copper (Cu) is formed on the pressing part 126 and the conductive layer 1361 made of silver (Ag) is formed in the first pole 136 made of ceramic. When the connection material 1261 and the conductive layer 1361 are exposed to air for a long time, oxidation occurs, resulting in an abnormal electrical connection of the connection material 1261 and the conductive layer 1361.

Conventionally, in order to prevent such oxidation, a sealing structure was formed such that the touch substrate 120 and the piezo disk 130 are not exposed to air.

However, such a sealing structure is complicated and a process of manufacturing the same is complicated, thereby decreasing productivity of the touch sensor assembly. In addition, such a sealing structure increases the size of the touch sensor assembly 100 and increases manufacturing costs.

In the present invention, in order to prevent such oxidation, oxidation prevention films 210 and 220 are formed on the exposed surfaces of the connection material 1261 and the conductive layer 1361.

For example, the oxidation prevention films 210 and 220 may be provided by coating a conductive material, which is not oxidized, on the exposed surfaces of the connection material 1261 and the conductive layer 1361.

Specifically, the oxidation prevention films 210 and 220 may be formed by coating a carbon or metal on the exposed surfaces of the connection material 1261 and the conductive layer 1361 using a silk screen method.

Carbon, gold, etc. are not oxidized by air or water and are positive conductors of electricity.

Accordingly, the connection material 1261 and the conductive layer 1361 are energized by the oxidation prevention films 210 and 220 and the exposed surfaces of the connection material 1261 and the conductive layer 1361 are prevented from being oxidized.

In addition, the oxidization prevention films 210 and 220 may be formed on at least one surface of the first pole 136 or the second pole 138 of the piezo disk 130 and the pressing part 126 or the fixing surface 128 of the touch substrate 120 and may be formed of various materials having conductivity while preventing oxidation. In addition, the oxidation prevention films 210 and 220 may be formed in the connection regions of the piezo disk 130 and the touch substrate 120 using various methods.

When the oxidation prevention films 210 and 220 are formed as described above, it is possible to prevent oxidation of the piezo disk 130 and the touch substrate 120 without the conventional complicated sealing structure.

In addition, it is possible to prevent electrical contact failure due to oxidation of the piezo disk 130 and the touch substrate 120.

In addition, by removing the sealing structure, it is possible to reduce a cost and to increase productivity.

In the embodiment of the present invention, a plurality of piezo disks is installed on the touch substrate. The wafer 150 for electrical connection with the piezo disk of the touch sensor assembly is provided outside the touch sensor assembly.

Referring to FIG. 4, the wafer 150 is installed on the touch substrate 120. According to the embodiments, the wafer 150 may be installed in a space between the holes of the touch substrate 120 on which the piezo disks 130 are installed and may be installed on the same surfaces as the surface, on which the holders 140 are fixed, of the touch substrate.

Hereinafter, an example of the order of assembling the touch sensor assembly will be described with reference to FIGS. 4 to 9.

First, the holder 140 is soldered and fixed to the rear surface (the opposite surface of the surface facing the front panel) of the touch substrate 120. Then, the wafer 150 is installed by an automated process.

Next, the piezo disk 130 is inserted between the holder 140 and the touch substrate 120. Since insertion of the piezo disk is guided by the guide groove 147 when the piezo disk 130 is inserted, it is possible to more easily insert the piezo disk. In addition, since the piezo disk 130 is circular but the side surface support 146 of the holder 140 substantially corresponds to the side of the rectangle, when only an end of the piezo disk 130 is inserted into the insertion part and the piezo disk is pressed from behind, the circular edge of the piezo disk 130 guides the piezo disk 130 such that the piezo disk is naturally aligned and inserted into the holder.

In particular, according to the embodiments, since the touch substrate 120 has an elongated rectangular shape, the long sides of the rectangular holes 122 are aligned in a direction corresponding to the longitudinal direction of the touch substrate, and the insertion parts of the holders 140 are provided in correspondence with the long sides of the holes, it is possible to insert the piezo disks 130 into the holders 140 at the side surface of the touch substrate 120. Therefore, insertion is more easily performed.

The front surface and the rear surface of the touch portions of the touch sensor assembly in a semi-assembled state in which the holder 140 is fixed to the touch substrate 120 and the piezo disk 130 is inserted are shown in FIGS. 10 and 11, respectively.

Next, a second adhesive member (not shown) is stacked on the rear surface of the holder 140 and the touch substrate 120. This may be performed through an automated process.

The first adhesive member 110 is stacked in a state of attaching a release paper is attached to the surface thereof and the release paper is removed when the touch sensor assembly 100 is attached to the front panel 20 of the refrigerator door 10, thereby preventing the adhesive strength of the surface of the first adhesive member 110 from being deteriorated.

In the above-described embodiments, the structure of the touch sensor assembly of the refrigerator and the method of manufacturing the same have been described. However, the above-described touch sensor assembly is applicable to various fields such as vehicle door panels, including the other types of home appliances, in addition to the refrigerator.

## Claims

1. A touch sensor assembly (100) comprising:
a touch substrate (120) configured to be attached to a panel (20) having a touch point (21); and
a piezo disk (130) fixed to the touch substrate (120) and having a first and a second pole (136, 138), the first pole (136) being disposed on a surface of the second pole (138) facing the touch substrate (120);
wherein the touch substrate (120) includes:
- a pressing part (126), which is flexibly provided on the touch substrate, which is in contact with the first pole (136) and electrically connected thereto, and which is electrically connected to a first wiring (1201) provided on the touch substrate (120), and
- a fixing surface (128) electrically connected to the second pole (138) and electrically connected to second wirings (1202) provided on the touch substrate (120); and
wherein an oxidation prevention film (210, 220) including a conductive material is formed in electrical connection regions of the piezo disk (130) and the touch substrate (120) and is disposed on at least one of the first pole (136), the second pole (138), the pressing part (126) and the fixing surface (128).

2. The touch sensor assembly (100) according to claim 1, wherein the oxidation prevention film (210, 220) includes carbon and/or gold (Au).

3. The touch sensor assembly (100) according to claim 1 or 2,
wherein the pressing part (126) is provided at a position of the touch substrate (120) corresponding to the touch point (21).

4. The touch sensor assembly (100) according to claim 1, 2 or 3,
wherein the pressing part (126) is provided within a hole in the touch substrate (120) and at least one leg part (124) connects the pressing part (126) to a circumferential surface of the hole (122), so that the pressing part (126) is flexibly provided on the touch substrate (120).

5. The touch sensor assembly (100) according to claim 4, wherein the first wiring (1201) is electrically connected to the pressing part (126) through the leg part (124).

6. The touch sensor assembly (100) according to any one of claims 4 or 5, wherein the at least one leg part (124) is provided radially around the pressing part (126) and/or is provided asymmetrically with respect to the pressing part (126).

7. The touch sensor assembly (100) according to any one of the preceding claims, further comprising a holder (140) for fixing the piezo disk (130) to the touch substrate (120) by supporting a rear surface of the piezo disk (130) facing away from the touch substrate (120), the holder (140) being fixed to the fixing surface (128).

8. The touch sensor assembly (100) according to claim 7,
wherein the holder (140) is made of a conductive material, and
wherein the second pole (138) of the piezo disk (130) is electrically connected to the fixing surface (128) by the holder (140).

9. The touch sensor assembly (100) according to any one of claims 7 or 8, wherein the holder (140) includes:
a rear support part (142) supporting the rear surface of the piezo disk (130);
a side support part (146) extending from the rear support part (142) toward the touch substrate (120) to support a side surface of the piezo disk (130); and
a fixing leg part (148) extending from the side support part (146) and fixed to the fixing surface (128) of the touch substrate (120).

10. The touch sensor assembly (100) according to any one of claims 7 to 9, wherein an insertion hole (141) for inserting the piezo disk (130) between the touch substrate (120) and the holder (140) is formed in one side of the holder (140).

11. The touch sensor assembly (100) according to claim 10,
wherein a guide groove (147) is recessed inward from an edge of the holder (140) including the insertion hole (141) in order to guide insertion of the piezo disk (130).

12. The touch sensor assembly (100) according to any one of claims 9 to 11,
wherein pressing projections (143) for pressing the piezo disk (130) towards the touch substrate (120) are provided on the rear support part (142).

13. The touch sensor assembly (100) according to claim 12,
wherein the pressing part (126) is configured to press a central portion of the piezo disk (130) and the pressing projections (143) are configured to press portions of the piezo disk (130) outside the central potion.

14. The touch sensor assembly (100) according to any one of claims 9 to 13, wherein slits (144) are formed around the center of the rear support part (142).

15. The touch sensor assembly (100) according to any one of the preceding claims, wherein a first adhesive member (110) is provided on the touch substrate (120) for adhering the touch substrate (120) to the panel (20).

## Patentansprüche

1. Berührungssensoranordnung (100), die Folgendes umfasst:
ein Berührungssubstrat (120), das konfiguriert ist, an einer Tafel (20) angebracht zu sein, die einen Berührungspunkt (21) aufweist;
eine Piezo-Scheibe (130), die an dem Berührungssubstrat (120) befestigt ist und einen ersten und einen zweiten Pol (136, 138) aufweist, wobei der erste Pol (136) auf einer Oberfläche des zweiten Pols (138) angeordnet ist, die dem Berührungssubstrat (120) zugewandt ist;
wobei das Berührungssubstrat (120) Folgendes enthält:
- eine Drückkomponente (126), die auf dem Berührungssubstrat flexibel vorgesehen ist, die sich mit dem ersten Pol (136) in Kontakt befindet und damit elektrisch verbunden ist und die mit einer ersten Verdrahtung (1201), die auf dem Berührungssubstrat (120) vorgesehen ist, elektrisch verbunden ist, und
- eine Befestigungsfläche (128), die mit dem zweiten Pol (138) elektrisch verbunden ist und mit einer zweiten Verdrahtung (1202), die auf dem Berührungssubstrat (120) vorgesehen ist, elektrisch verbunden ist; und
wobei ein Oxidationsverhinderungsfilm (210, 220), der ein leitfähiges Material enthält, in Bereichen der elektrischen Verbindung der Piezo-Scheibe (130) und des Berührungssubstrats (120) gebildet ist und auf dem ersten Pol (136) und/oder dem zweiten Pol (138) und/oder der Drückkomponente (126) und/oder der Befestigungsfläche (128) angeordnet ist.

2. Berührungssensoranordnung (100) nach Anspruch 1, wobei der Oxidationsverhinderungsfilm (210, 220) Kohlenstoff und/oder Gold (Au) enthält.

3. Berührungssensoranordnung (100) nach Anspruch 1 oder 2,
wobei die Drückkomponente (126) an einer Position des Berührungssubstrats (120) vorgesehen ist, die dem Berührungspunkt (21) entspricht.

4. Berührungssensoranordnung (100) nach Anspruch 1, 2 oder 3,
wobei die Drückkomponente (126) in einem Loch im Berührungssubstrat (120) vorgesehen ist und mindestens eine Beinkomponente (124) die Drückkomponente (126) mit einer Umfangsfläche des Lochs (122) verbindet, derart, dass die Drückkomponente (126) auf dem Berührungssubstrat (120) flexibel vorgesehen ist.

5. Berührungssensoranordnung (100) nach Anspruch 4, wobei die erste Verdrahtung (1201) durch die Beinkomponente (124) mit der Drückkomponente (126) elektrisch verbunden ist.

6. Berührungssensoranordnung (100) nach einem der Ansprüche 4 oder 5, wobei die mindestens eine Beinkomponente (124) radial um die Drückkomponente (126) vorgesehen ist und/oder in Bezug auf die Drückkomponente (126) asymmetrisch vorgesehen ist.

7. Berührungssensoranordnung (100) nach einem der vorhergehenden Ansprüche, die ferner einen Halter (140) zum Befestigen der Piezo-Scheibe (130) am Berührungssubstrat (120) durch Tragen einer Rückfläche der Piezo-Scheibe (130), die vom Berührungssubstrat (120) abgewandt ist, umfasst, wobei der Halter (140) an der Befestigungsfläche (128) befestigt ist.

8. Berührungssensoranordnung (100) nach Anspruch 7,
wobei der Halter (140) aus einem leitfähigen Material hergestellt ist und
wobei der zweite Pol (138) der Piezo-Scheibe (130) durch den Halter (140) mit der Befestigungsfläche (128) elektrisch verbunden ist.

9. Berührungssensoranordnung (100) nach einem der Ansprüche 7 oder 8, wobei der Halter (140) Folgendes enthält:
eine rückwärtige Trägerkomponente (142), die die Rückfläche der Piezo-Scheibe (130) trägt;
eine Seitenträgerkomponente (146), die sich von der rückwärtigen Trägerkomponente (142) in Richtung des Berührungssubstrats (120) erstreckt, um eine Seitenfläche der Piezo-Scheibe (130) zu tragen; und
eine Befestigungsbeinkomponente (148), die sich von der Seitenträgerkomponente (146) erstreckt und an der Befestigungsfläche (128) des Berührungssubstrats (120) befestigt ist.

10. Berührungssensoranordnung (100) nach einem der Ansprüche 7 bis 9, wobei ein Einsetzloch (141) zum Einsetzen der Piezo-Scheibe (130) zwischen dem Berührungssubstrat (120) und dem Halter (140) in einer Seite des Halters (140) gebildet ist.

11. Berührungssensoranordnung (100) nach Anspruch 10,
wobei eine Führungsrille (147) von einer Kante des Halters (140), die das Einsetzloch (141) enthält, nach innen vertieft ist, um das Einsetzen der Piezo-Scheibe (130) zu führen.

12. Berührungssensoranordnung (100) nach einem der Ansprüche 9 bis 11,
wobei Drückvorsprünge (143) zum Drücken der Piezo-Scheibe (130) in Richtung des Berührungssubstrats (120) auf der rückwärtigen Trägerkomponente (142) vorgesehen sind.

13. Berührungssensoranordnung (100) nach Anspruch 12,
wobei die Drückkomponente (126) konfiguriert ist, auf einen Mittenabschnitt der Piezo-Scheibe (130) zu drücken und die Drückvorsprünge (143) konfiguriert sind, auf Abschnitte außerhalb des Mittenabschnitts der Piezo-Scheibe (130) zu drücken.

14. Berührungssensoranordnung (100) nach einem der Ansprüche 9 bis 13, wobei um die Mitte der rückwärtigen Trägerkomponente (142) Schlitze (144) gebildet sind.

15. Berührungssensoranordnung (100) nach einem der vorhergehenden Ansprüche, wobei ein erstes Haftelement (110) zum Anhaften des Berührungssubstrats (120) an die Tafel (20) auf dem Berührungssubstrat (120) vorgesehen ist.

## Revendications

1. Ensemble de capteur tactile (100) comportant :
un substrat tactile (120) configuré pour être fixé à un panneau (20) ayant un point tactile (21) ; et
un disque piézo-électrique (130) fixé au substrat tactile (120) et ayant un premier et un second pôle (136, 138), le premier pôle (136) étant disposé sur une surface du second pôle (138) dirigée vers le substrat tactile (120) ;
dans lequel le substrat tactile (120) inclut :
- une partie de pression (126), qui est agencée sur le substrat tactile de manière souple, qui est en contact avec le premier pôle (136) et électriquement reliée à celui-ci, et qui est électriquement reliée à un premier câblage (1201) agencé sur le substrat tactile (120), et
- une surface de fixation (128) électriquement reliée au second pôle (138) et électriquement reliée à des seconds câblages (1202) agencés sur le substrat tactile (120) ; et
dans lequel un film de prévention d'oxydation (210, 220) incluant un matériau conducteur est formé dans des zones de liaison électrique du disque piézo-électrique (130) et du substrat tactile (120) et est disposé sur au moins un élément parmi le premier pôle (136), le second pôle (138), la partie de pression (126) et la surface de fixation (128).

2. Ensemble de capteur tactile (100) selon la revendication 1, dans lequel le film de prévention d'oxydation (210, 220) inclut du carbone et/ou de l'or (Au).

3. Ensemble de capteur tactile (100) selon la revendication 1 ou 2,
dans lequel la partie de pression (126) est agencée à une position du substrat tactile (120) correspondant au point tactile (21).

4. Ensemble de capteur tactile (100) selon la revendication 1, 2 ou 3,
dans lequel la partie de pression (126) est agencée à l'intérieur d'un trou dans le substrat tactile (120) et au moins une partie de canal (124) relie la partie de pression (126) à une surface circonférentielle du trou (122), de sorte que la partie de pression (126) est agencée sur le substrat tactile (120) de manière souple.

5. Ensemble de capteur tactile (100) selon la revendication 4, dans lequel le premier câblage (1201) est électriquement relié à la partie de pression (126) par l'intermédiaire de la partie de canal (124).

6. Ensemble de capteur tactile (100) selon l'une quelconque des revendications 4 ou 5, dans lequel la au moins une partie de canal (124) est agencée radialement autour de la partie de pression (126) et/ou est agencée asymétriquement par rapport à la partie de pression (126).

7. Ensemble de capteur tactile (100) selon l'une quelconque des revendications précédentes, comportant en outre un support (140) pour fixer le disque piézo-électrique (130) au substrat tactile (120) en supportant une surface arrière du disque piézo-électrique (130) s'écartant du substrat tactile (120), le support (140) étant fixé à la surface de fixation (128).

8. Ensemble de capteur tactile (100) selon la revendication 7,
dans lequel le support (140) est constitué d'un matériau conducteur, et
dans lequel le second pôle (138) du disque piézo-électrique (130) est électriquement relié à la surface de fixation (128) par le support (140).

9. Ensemble de capteur tactile (100) selon l'une quelconque des revendications 7 ou 8, dans lequel le support (140) inclut :
une partie de support arrière (142) supportant la surface arrière du disque piézo-électrique (130) ;
une partie de support latérale (146) s'étendant à partir de la partie de support arrière (142) vers le substrat tactile (120) pour supporter une surface latérale du disque piézo-électrique (130) ; et
une partie de canal de fixation (148) s'étendant à partir de la partie de support latérale (146) et fixée à la surface de fixation (128) du substrat tactile (120).

10. Ensemble de capteur tactile (100) selon l'une quelconque des revendications 7 à 9, dans lequel un trou d'insertion (141) pour insérer le disque piézo-électrique (130) entre le substrat tactile (120) et le support (140) est formée dans un côté du support (140).

11. Ensemble de capteur tactile (100) selon la revendication 10,
dans lequel une gorge de guidage (147) est évidée vers l'intérieur à partir d'un bord du support (140) incluant le trou d'insertion (141) afin de guider l'insertion du disque piézo-électrique (130).

12. Ensemble de capteur tactile (100) selon l'une quelconque des revendications 9 à 11,
dans lequel des saillies de pression (143) destinées à presser le disque piézo-électrique (130) vers le substrat tactile (120) sont agencées sur la partie de support arrière (142).

13. Ensemble de capteur tactile (100) selon la revendication 12,
dans lequel la partie de pression (126) est configurée pour presser une portion centrale du disque piézo-électrique (130) et les saillies de pression (143) sont configurées pour presser des portions du disque piézo-électrique (130) à l'extérieur de la portion centrale.

14. Ensemble de capteur tactile (100) selon l'une quelconque des revendications 9 à 13, dans lequel des fentes (144) sont formées autour du centre de la partie de support arrière (142).

15. Ensemble de capteur tactile (100) selon l'une quelconque des revendications précédentes, dans lequel un premier élément adhésif (110) est agencé sur le substrat tactile (120) pour faire adhérer le substrat tactile (120) au panneau (20).
